# EUROPEAN PATENT APPLICATION

(11) **EP 1 635 387 A1**
(43) Date of publication of application: **15.03.2006**
(21) Application number: 05018890.3
(22) Date of filing: 31.08.2005
(51) Int. Cl.: H01L 21/60, H01L 23/14

(54) **Electronic device with a chip on a pedestal and method of manufacturing the same**

(30) Priority: 09.09.2004 JP 2004262271; 25.03.2005 JP 2005089524; 22.07.2005 JP 2005212858
(71) Applicant: SEIKO EPSON CORPORATION, Shinjuku-ku, Tokyo 163-0811 (JP)
(72) Inventor: Hashimoto, Nobuaki, Suwa-shi Nagano-ken 392-8502 (JP)
(74) Representative: HOFFMANN EITLE

(57) **Abstract**

An electronic device including a substrate provided with a first wiring formed thereon; and a pedestal provided above the substrate and provided with a second wiring formed thereon, wherein the second wiring is connected to the first wiring on the substrate.

## Description

### BACKGROUND OF THE INVENTION

### 1. Technical Field

The present invention relates to an electronic device and a method of manufacturing the electronic device.

### 2. Related Art

. In recent years, researches and developments for manufacturing subminiature supersmart electronic components (MEMS elements) using MEMS (Micro Electro Mechanical System) technology are actively executed. There are various kinds of electronic components using the MEMS technology, in which inkjet heads composing inkjet printers, for example, are well known as a kind of such components. Incidentally, regarding electronic components (electronic devices) manufactured using the MEMS technology and electronic components manufactured using technologies other than the MEMS technology, there are some cases in which wiring formed on the substrate cannot be connected directly on the surface of the substrate to terminals of components such as semiconductor chips mounted on the substrate for the reason of a limitation in the area of the substrate composing the electronic component or other reasons.

For example, in case a semiconductor chip having connection terminals exposed on the side surface is mounted on the substrate, it is difficult to directly connect the connection terminals with the wiring of the substrate.
In view of the above, a technology is proposed in which wiring connected to the connection terminals provided on the side surface of the semiconductor chip is extended on the upper surface thereof to connect the wiring with the wiring provided on the substrate, thereby providing electrical conduction between the connection terminals of the semiconductor chip and the wiring of the substrate via the wiring provided on the surface of the semiconductor chip. Such a technology is disclosed, for example, in the specification of the U.S. patent publication No. 6646289.

However, the connecting section of the connection terminal exposed on the side surface of the semiconductor chip with the wiring provided on the side surface forms like a strip, and accordingly, the connection terminal and the wiring problematically form a line contact. Therefore, there is caused a problem in connection reliability that breaking is easy to be caused in the connecting section of the connection terminal with the wiring of the substrate by an external stress or a bending force applied thereto.
Incidentally, such a method can be considered that the semiconductor chip is mounted on a step provided on the substrate with a pedestal or the like if it is difficult to mount the semiconductor chip directly on the substrate. SUMMARY

In view of the above technical background, the present invention offers an advantage of providing an electronic device and a method of manufacturing the electronic device capable of preventing a junction between wiring formed on the substrate and wiring to be connected to the substrate from breaking to enhance the connection reliability, as well as simplifying a connection process between the wiring.

According to an aspect of the invention, an electronic device includes a substrate provided with a first wiring formed thereon, and a pedestal provided above the substrate and provided with a second wiring formed thereon, wherein the second wiring is connected to the first wiring on the substrate.

According to the electronic device, since the second wiring formed on the pedestal and the first wiring formed of the substrate are connected to each other on the substrate, and the junction between the first and the second wiring is formed of their surfaces, the first and the second wiring can electrically be connected with high reliability. Further, since the junction between the first and the second wiring is formed of their surfaces, the strength of the junction can be increased. For example, when a external force caused by bending or dropping is applied to the junction, the junction can be prevented from breaking, thus enhancing the reliability of the connection between the first and second wiring, and accordingly, the reliability of the electronic device provided with the junction can also be enhanced.

Further, at least a part of the end face of the pedestal preferably forms an incline at an angle with the upper surface of the substrate.
By thus configured, breaking of the second wiring caused by acutely bending the wiring can be prevented by laying down the second wiring on the incline, and thus enhancing the reliability of the electronic device.
Further, the incline preferably forms an acute angle with the upper surface of the substrate.
By thus configured, the pitch of the end face of the pedestal with respect to the upper surface of the substrate can be lowered, thus breaking of the second wiring caused by being bent acutely can further reliably be prevented.

Further, the pedestal is preferably provided with an additional component connected to the second wiring.
By thus configured, since the additional component provided on the pedestal is connected to the second wiring, it can electrically be connected to the first wiring via the second wiring. Therefore, if, for example, the additional component is required to be mounted on a position with a step from the substrate from a restriction of the substrate, the additional component can electrically be connected to the substrate via the first wiring on the substrate and the second wiring on the pedestal by adopting the invention.

Further, the second wiring can be connected to the upper surface of the additional component.
By thus configured, after mounting the additional component on the pedestal, the connection of the additional component to the second wiring and the forming of the second wiring can be executed at the same time, thus simplifying the manufacturing process of the electronic device.

Further, the additional component is preferably an IC chip.
By thus configured, since the IC chip can be mounted with a step between the substrate and the IC chip even with any restriction in the substrate, the IC chip can be mounted in a dense state, thus miniaturizing the electronic device.

Further, in the electronic device, the pedestal preferably includes a plurality of sub-pedestals stacked one another.
By thus configured, since the pedestal has a multi-tiered structure, the electronic device itself can have a multi-tiered structure.

According to another aspect of the invention, an electronic device includes a substrate provided with a first wiring formed thereon, and an additional component provided above the substrate and provided with a second wiring formed on an upper surface thereof, wherein the second wiring is connected to the first wiring on the substrate.

According to the electronic device, since the second wiring formed on the additional component and the first wiring formed of the substrate are connected to each other on the substrate, and the junction between the first and the second wiring is formed of their surfaces, the first and the second wiring can electrically be connected with high reliability. Therefore, since the junction between the first wiring and the second wiring is formed of their surfaces, the strength of the junction can be increased, and accordingly, the reliability of the electronic device provided with the junction having high connection reliability can also be enhanced.
Further, when, for example, the additional component is a semiconductor device, the connection between the second wiring and a terminal surface (the upper surface) of the semiconductor and the connection between the first wiring and the second wiring are executed simultaneously by forming the second wiring, thus simplifying the wiring forming process for providing connection to the semiconductor.

In the electronic device, the additional component is preferably an IC chip.
By thus configured, since the IC chip can be mounted with a step between the substrate and the IC chip even with any restriction in the substrate, the IC chip can be mounted in a dense state, thus miniaturizing the electronic device.

According to still another aspect of the invention, a method of manufacturing an electronic device includes the step of forming a first wiring and a pedestal on a substrate, and the step of forming a second wiring above the substrate so as to be connected to the first wiring on the substrate and is laid down onto the pedestal.

According to the manufacturing method of an electronic device, the second wiring is formed on the first wiring after the first wiring is formed on the substrate, thus the first wiring and the second wiring are electrically connected with high reliability. Further, since the junction between the first wiring and the second wiring is provided on the substrate and is composed of their surfaces, the strength of the junction can be increased.
Therefore, the electronic device having enhanced connection reliability can be obtained by preventing breaking of the junction when external forces caused by, for example, bending or dropping are applied to the junction.

Further, at least a part of the end face of the pedestal preferably forms an incline at an angle with the upper surface of the substrate.
By thus configured, breaking of the second wiring caused by acutely bending the wiring can be prevented by laying down the second wiring on the incline to decrease the height of the step generated between the pedestal and the substrate, and thus enhancing the reliability of the electronic device.
Further, if, for example, the second wiring is formed by depositing a conductive material by a sputtering process and then exposing the photoresist, focus adjustment for the exposure process can easily be executed because of the incline provided to the end face of the pedestal. Therefore, the second wiring reliably connecting the upper surface of the substrate with the upper surface of the pedestal can be formed.
Further, the incline preferably forms an acute angle with the upper surface of the substrate.
By thus configured, since the pitch between the pedestal and the upper surface of the substrate becomes lower, breaking of the second wiring caused by being bent acutely can surely be prevented, thus the reliability of the electronic device can be enhanced.

Further, the pedestal is preferably provided with an additional component connected to the second wiring.
By thus configured, since the additional component provided on the pedestal is connected to the second wiring, it can electrically be connected to the first wiring via the second wiring with high reliability. Therefore, even in case the substrate is connected to the additional component with a step therebetween, the first wiring and the additional component can electrically be connected via the second wiring by using the present aspect of the invention.

Further, it is preferable to include the step of mounting the additional component on the pedestal, and in the step of forming the second wiring, the second wiring is connected to an upper surface of the additional component.
By thus configured, the second wiring to be connected to the upper surface of the additional component is formed after the additional component is mounted on the pedestal. Therefore, the formation of the second wiring and the connection with the additional component can be executed at the same time, thus the manufacturing process of the electronic device can be simplified.

Further, the additional component is preferably an IC chip.
By thus configured, since the IC chip can be mounted with a step between the substrate and the IC chip even with any restriction in the substrate, the IC chip can be mounted in a dense state, thus miniaturizing the electronic device.

Further, an insulating section is preferably provided to at least a part of the side of the IC chip, and the end face of the insulating section preferably forms an incline at an angle with the upper surface of the pedestal.
By thus configured, since the insulating section is formed on the side of the IC chip, the second wiring is insulated in other sections than the terminal section of the IC chip, thus preventing short circuit in the side of the IC chip.
Further, since the insulating section is provided with an incline, breaking of the second wiring caused by being bent acutely can be prevented especially by laying down the second wiring on the incline. Therefore, the reliability of the electronic device can be enhanced by connecting the first wiring on the substrate and the IC chip via the second wiring with high reliability.
Further, if, for example, the second wiring is formed by a sputtering process or exposing the photoresist as described above, the focus adjustment can easily be executed on the incline, and accordingly, the second wiring can easily be formed.
Further, the incline preferably forms an acute angle with the upper surface of the pedestal.
By thus configured, the pitch of the incline can be lowered, thus breaking of the second wiring can reliably be prevented.

### BRIEF DESCRIPTION OF THE DRAWINGS

The invention will now be described with reference to the accompanying drawings, wherein like numbers refer to like elements, and wherein:
Fig. 1 is a side cross-sectional view of an electronic device according to a first embodiment of the invention.
Fig. 2 is a plan view of the electronic device according to the first embodiment of the invention.
Figs. 3A through 3D are cross-sectional views for explaining a manufacturing process of the electronic device according to the first embodiment of the invention.
Fig. 4 is a side cross-sectional view of an electronic device according to a second embodiment of the invention.
Fig. 5 is a plan view of the electronic device according to the second embodiment of the invention.
Figs. 6A through 6F are cross-sectional views for explaining a manufacturing process of the electronic device according to the second embodiment of the invention.
Fig. 7 is a side cross-sectional view of an electronic device according to a third embodiment of the invention.
Fig. 8 is a side cross-sectional view with another shape of the insulating section.
Fig. 9 is a side cross-sectional view with another shape of the insulating section.
Fig. 10 is a side cross-sectional view with another shape of the insulating section.
Fig. 11 is a side cross-sectional view with another shape of the insulating section.

### DESCRIPTION OF THE EMBODIMENTS

(Electronic Device)
The invention will be explained hereinafter in detail.

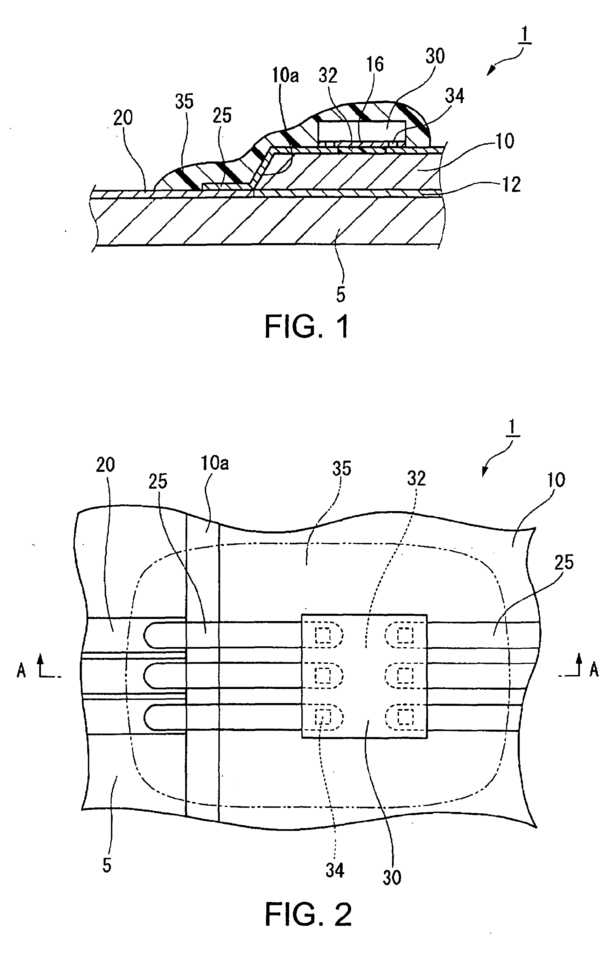

Fig. 1 is a view for explaining an electronic device manufactured using a method of manufacturing an electronic device according to the present embodiment of the invention, and is a cross-sectional view along the A-A line in Fig. 2. In Fig. 1, the reference numeral "1" denotes the electronic device of the present embodiment. Fig. 2 is a plan view with a partial sight through section (resin 35 described below) for explaining the electronic device 1 according to the present embodiment.

As shown in Fig. 1, the electronic device 1 is equipped with a substrate 5 made of, for example, Si and a pedestal 10 formed on the substrate 5. The pedestal 10 is, for example, a plate like member made of a material such as Si or ceramic. Further, the pedestal 10 can be another component composed of an organic substrate or an electrical component.
In the present embodiment, the pedestal 10 is preferably a member made of Si which is also a material of the substrate 5. Because, if different materials are used for the substrate 5 and the pedestal 10, a stress is caused by the difference in thermal expansion coefficients, whose effect must be reduced. Further, the height of the pedestal 10 is arranged to be 400 µm. And the pedestal 10 is arranged to be adhered onto the substrate 5 via an adhesive layer 12 composed mainly of an adhesive. Note that, as a method of adhering the pedestal 10 to the substrate 5, a method without using the adhesive layer 12 composed of an adhesive such as room temperature bonding or interatomic bonding can be adopted. Further, the electronic device 1 according to the present embodiment of the invention is assumed to be used in a case in which an additional component is required to be mounted on the substrate 5 with a difference in height between the surface of the substrate 5 and the component.

On the substrate 5, there is formed a first wiring 20 forming a wiring pattern made by, for example, plating and connected to a peripheral circuit (not shown) or the like. On the pedestal 10, there is formed a second wiring 25 to be electrically connected to the first wiring 20, and the first wiring 20 and the second wiring 25 are actually connected to each other on the substrate 5. The second wiring 25 can be formed by a plating process, a sputtering process, a sputtering mask process, a CVD process, an inkjet process, or the like.

The end face of the pedestal 10 is arranged to form an incline 10a slopes at an acute angle (an angle greater than 0 and smaller than 90 degree) with the upper surface of the substrate 5.
In further detail, if the pedestal 10 is formed by an anisotropic etching process using Si with the surface orientation of (110), the angle of the incline 10a with respect to the upper surface of the substrate 5 is 54.3 degree.
Note that the end face of the pedestal 10, in the present embodiment of the invention, includes the peripheral face of the pedestal 10 and inner surfaces of any openings provided to the pedestal 10.
And, the second wiring 25 connected to the first wiring 20 disposed on the substrate 5 is formed so as to be extended to the upper surface of the pedestal 10 through the incline 10a. The wiring pattern 20 can also be formed under the adhesive layer 12. Further, the angle of inclination of the incline 10a is preferably small. Note that, since it is enough to form the wiring on the incline 10a, the angle of inclination of the incline 10a can be nearly upright if the condition of the sputtering process or the photo process allows, or even vertical (90 degree) if it is thin enough. Still further, if the second wiring is formed by the CVD process, for example, the incline 10a of the pedestal 10 can be formed at an obtuse angle (an angle larger than 90 and smaller than 180 degree) with the surface of the substrate 5.

On the pedestal 10, there is provided an IC chip 30 (the additional component).
Note that, if the additional component formed on the pedestal 10 is the IC chip 30 as is the case with the present embodiment, the electronic device 1 can be called a semiconductor device.
On a first surface 32 of the IC chip 30, there is formed a plurality of electrodes 34 as shown in Fig. 2. The first surface 32 can be a quadrangle (e.g., a rectangle). The plurality of electrodes 34 can be formed on the peripheral edge (end section) of the first surface 32. For example, the plurality of electrodes 34 can be aligned along the four sides of the first surface 32 or can be aligned along either two sides of thereof. At least one of the electrodes 34 can be disposed in a center portion of the first surface 32.

As shown in Fig. 1, the first surface 32 is provided with a passivation film 16, the electrically insulating film composed at least of one layer formed thereon. The passivation film 16 can be composed only of a non-resin material (e.g., SiO₂ or SiN), can include a film made of resin (e.g., polyimide resin) thereon, or can be composed only of a resin layer. The passivation film 16 is provided with openings for exposing at least a part (e.g., a center section thereof) of the electrodes 34. In other wards, the passivation film 16 is formed so as not to cover at least a center section (a section to be connected to the second wiring 25) of each of the electrodes 34. Further, the end sections of the electrodes 34 can be covered by the passivation film 16, and alternatively, the whole of the first surface 32 can be covered by the passivation film 16.

As shown in Fig. 2, the electrodes 34 are electrically connected to the second wiring 25 by contacting the second wiring 25. Further, the first wiring 20 and the second wiring 25 are connected to each other with their surfaces.
As shown in Fig. 1, the connection section of the first wiring 20 with the second wiring 25 and the IC chip 30 are covered by resin 35 composed of, for example, epoxy resin or silicone resin, thus protected from impacts or moisture from outside.
Further, the pedestal 10 and the substrate 5 are described on the premise that they have enough insulating properties in the present embodiment. However, if the insulating properties of the surfaces are not enough or they do not have any insulating properties, it is preferable to previously form an insulating layer on each surface of the pedestal 10 and the substrate 5 on which the wiring is to be formed. Specifically, an oxide film, a nitride film, resin, or the like can be formed by an appropriate method (e.g., a sputtering process or a spin-coating process).
Note that, although a so-called facedown mounting method in which the IC chip is mounted on the pedestal 10 with its side having the electrodes 34 face down is illustrated in Figs. 1 and 2, a wire bonding method can also be adopted in which the IC chip is mounted with its side having the electrodes 34 face up and the electrodes 34 and the second wiring 25 are connected with wires made of Au, Al or the like.

### (Method of Manufacturing Electronic Device)

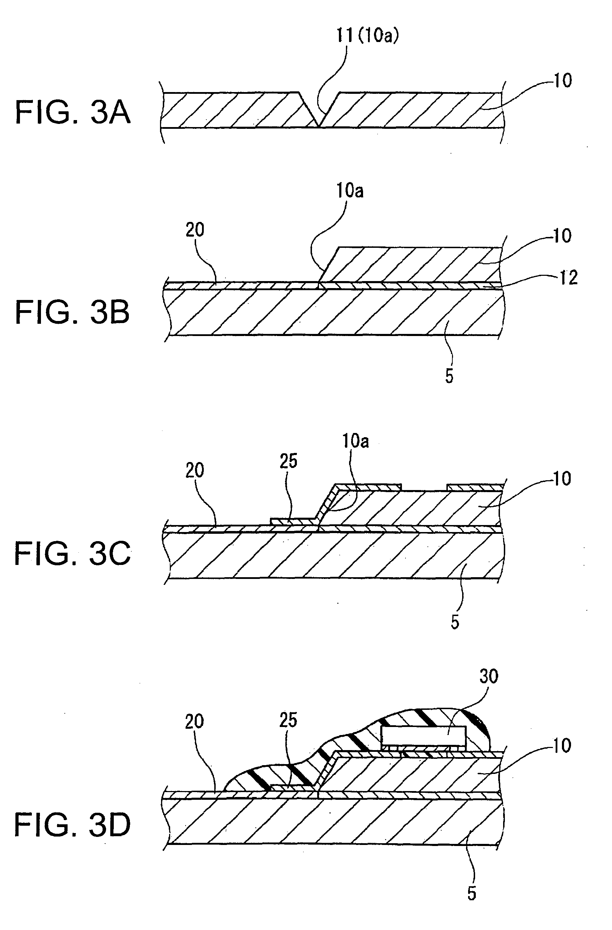

A method of manufacturing the electronic device 1 according to the present embodiment of the invention will now be described with reference to Figs 3A through 3D.
As shown in Fig. 3A, a V groove 11 for facilitating formation of the second wiring 25 described later is provided to the pedestal 10 made of Si as described above. As a method of forming the V groove 11, an anisotropic etching process or a mechanical process using a blade of sloping shape (bevel cut) for dicing can be used. After dividing the pedestal 10 into two pieces at the bottom of the V groove 11, one of the two pieces of pedestal 10 having the incline 10a is taken to be used. Note that an inclined face formed by shrinkage of resin or the like can also be utilized. Further, the process for forming an insulating film described above can also be executed if necessary. Further, the end section of the pedestal 10 can be arranged to be shaped as the incline 10a not having a vertical or acute angle but having an obtuse angle.

Subsequently, as shown in Fig. 3B, the first wiring 20 is formed on the substrate 5 by a plating process, a sputtering process, a sputtering mask process, a CVD process, or an inkjet process using a material such as Cu, Ni-P, or Au. Note that the first wiring 20 can previously be formed on the substrate 5. Further, the first wiring 20 can be formed by a sputtering process or etching a metal foil adhered onto the substrate 5. The process for forming an insulating film described above can previously be executed also on the substrate prior to the formation of the wiring if necessary.
The pedestal 10 is aligned and then adhered to the substrate 5 via the adhesive layer12. Further, a sheet-like adhesive previously attached to the pedestal 10 can be used instead of the adhesive layer 12, or alternatively, other fixing method then the adhesive bonding process, such as a metal diffusion bonding process, a melting process, or a soldering process can also adopted.

Subsequently, as shown in Fig. 3C, the second wiring 25 which is connected to the first wiring 20 and extended onto the pedestal 10 is formed.
Firstly, a metal film which is a material of the second wiring is formed by a sputtering process so as to cover the first wiring 20 and the pedestal 10. Various materials having superior conductivity can be adopted as a material of the metal film. For example, in case two layered metal film is used, a material having superior adhesion strength such as Ti, W, Ti-W, Ni, or Cr can be used as a first layer, and a material having low resistivity such as Cu, Al, or Au can be used as a second layer. Further, a single layered metal film can be formed by using Al as the material. If silicon is used as the substrate 5 or the pedestal 10, superior matching with various metals mentioned above can be provided.
Note that a plasma process can be executed prior to the sputtering process to enhance adhesiveness with the metal film.
Subsequently the whole surface of the metal film is coated with photo resist. When coating with the photo resist, the connection section of the substrate 5 with the pedestal 10 needs to be also coated with the photo resist, thus increasing unevenness. Therefore, it is preferable to use a spray coating process for coating the photo resist in the present embodiment of the invention. Of course, other methods known to the public can also be adopted.
After then, the photo resist is cured by a heat treatment and then an exposure process and a development process are executed to obtain the second wiring 25 of a desired pattern. In this case, since the second wiring 25 is formed so as to overlap above the substrate 5 with the first wiring 20 disposed on the substrate 5, the first wiring 20 and the second wiring 25 contact each other with their surfaces. Further, if the incline 10a is formed on the end face of the pedestal 10, the incline 10a faces toward the sputtering target to enhance ability to cover an uneven surface. Therefore, the thickness of the film is stabilized to expose the whole surface of the coated photo resist, thus stable exposure can be realized.
Therefore, the second wiring 25 can stably connect the upper surface of the substrate 5 and the upper surface of the pedestal 10 via the incline 10a.
Thus, the second wiring 25 which is connected to the first wiring 20 and is extended onto the upper surface of the pedestal 10 can be formed.

Subsequently, as shown in Fig. 3D, the IC chip 30 is mounted on the second wiring 25. In order for connecting the electrodes 34 provided to the IC chip 30 to the second wiring 25, the IC chip 30 is mounted with its side having the electrodes 34 face down and then the electrodes 34 and the second wiring 25 are connected to each other via, for example, solder. Although not shown in the drawings, a space between the IC chip 30 and the pedestal 10 is preferably filled with resin in order to enhance connection reliability. Further, since other methods such as various metal bonding methods using gold bumps or a resin pressure contact method are proposed as the face down mounting method other than the soldering method, such methods can surely be adopted.
Further, the wire bonding method can be used in which the IC chip is mounted on the second wiring 25 with the face up orientation (its side with the electrodes 34 face up) and then the electrodes 34 and the second wiring 25 are connected to each other with wires made of Au, Al, or the like.
After mounting the IC chip 30, it is sealed with the resin 35 composed of epoxy resin, silicone resin, or the like described above so as to protect the connection sections of the first wiring 20 with the second wiring 25 and the connection sections of the IC chip 30 with the second wiring 25.
In this case, low stress resin is preferably used as the resin 35 to make it difficult to cause a residual stress of the resin 35 sealing the wiring connection sections. By thus configured, since the wiring connection sections, the wiring sections, and the IC chip mounting sections are covered from the substrate with the resin, in particular the reliability in the moisture resistance property can be improved.
The electronic device 1 according to the present embodiment of the invention is manufactured by the processes described above.

According to the electronic device 1 described above, the structure can be realized in which the first wiring 20 formed on the substrate 5 and the second wiring 25 formed on the pedestal 10 are connected to each other on the substrate 5. Here, since the first wiring 20 and the second wiring 25 is connected in the connection sections not with lines but with their surfaces having substantial areas, the strength of the connection sections can be increased compared to a line contact, thus preventing disconnection to surely connect the first wiring 20 to the second wiring 25. Therefore, the reliability of the connection sections of the first wiring 20 with the second wiring 25 can be enhanced, in particular, the connection reliability in a reliability examination for testing the thermal cycle resistance, bending or dropping reliability can be improved.
Further, since the pedestal 10 is provided on the substrate 5, electrical conduction in the higher position than the substrate 5 can be achieved by extending the second wiring 25 on the pedestal 10.

Still further, if the incline 10a at an angle with the upper surface of the substrate 5 is provided to the end face of the pedestal 10, the second wiring is prevented from bending sharply at the connection section on the substrate 5, thus preventing the second wiring 25 from breaking. Further, since the incline 10a is an inclined surface at an acute angle with the upper surface of the substrate 5, the inclination pitch of the incline becomes lower to make it difficult to cause breaking of the second wiring 25, thus more surely preventing the second wiring 25 from breaking to enhance the reliability of the electronic device 1. Note that, in case the second substrate 25 is formed by a CVD process, the incline 10a of the pedestal 10 can be formed so as to have an obtuse angle with the upper surface of the substrate 5.

Further, on the pedestal 10, there is provided the IC chip 30 connected to the second wiring 25.
Therefore, since the electrodes 34 of the IC chip 30 provided on the pedestal 10 are connected to the second wiring 25, the electrodes 34 can electrically be connected to the first wiring 20 on the substrate 5 via the second wiring 25. And accordingly, even if the IC chip 30 needs to be mounted on a higher position than the surface of the substrate 5 under a restriction of the substrate 5 in mounting the IC chip 30 on the substrate 5, the first wiring 20 on the substrate 5 can electrically be connected to the IC chip 30 via the second wiring 25 on the pedestal 10 by using the present embodiment of the invention.

According to the method of manufacturing the electronic device 1 described above, since the second wiring 25 is formed on the first wiring 20 overlapped thereon, the first wiring 20 and the second wiring 25 can surely be connected to each other with their surfaces on the substrate 5, thus increasing the strength of the connection sections.
Therefore, in particular, the connection reliability in the reliability examination including the thermal cycle resistance, bending or dropping reliability can be improved. Further, the connection reliability can be enhanced by preventing the bonding section from breaking. Still further, since the formation of the second wiring 25 and the connection with the first wiring 20 can be executed at the same time, the number of steps of manufacturing the electronic device 1 can be reduced.

Further, the end face of the pedestal 10 is formed as the incline 10a as described above, and the second wiring 25 laid down on the incline 10a can be prevented from being acutely bent. Still further, by making it difficult to cause the second wiring 25 to break by using the incline 10a forming an acute angle, the second wiring can more surely be prevented from breaking, thus enhancing reliability of the electronic device 1.

Further, on the pedestal 10, there is provided the IC chip 30 connected to the second wiring 25.
Therefore, since the IC chip 30 provided on the pedestal 10 is connected to the second wiring 25, the IC chip 30 mounted thereon at a higher position than the surface of the substrate 5 can be electrically connected to the first wiring 20 on the substrate 5 via the second substrate 25. By thus configured, the IC chip 30 can be disposed even if it is required to be mounted above the surface of the substrate 5 apart therefrom by a positive reason. Further, even if the IC chip 30 cannot be mounted directly on the substrate 5 from a design restriction of the substrate 5, by applying the present embodiment of the invention capable of mounting the IC chip 30 with the pedestal 10 provided between the substrate 5 and the IC chip 30, the IC chip 30 can be mounted on the substrate 5 in a dense state, thus miniaturizing the electronic device 1.

An electronic device according to a second embodiment of the invention is hereinafter described.

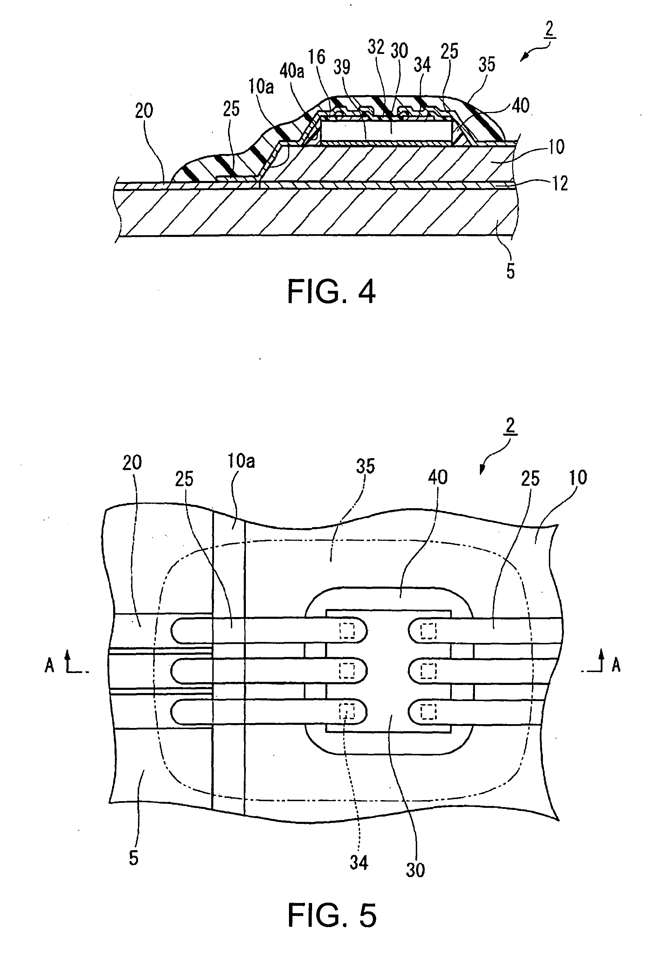

Figs. 4 and 5 are views for explaining the electronic device according to the second embodiment, wherein Fig. 4 is a cross-sectional view along a line defined by the A-A arrow in Fig. 5. In Fig. 4, the reference numeral "2" denotes the electronic device of the present embodiment. Fig. 5 is a plan view with a partial sight through section (resin 35 described below) for explaining the electronic device 2 according to the present embodiment.
Note that, in the electronic device 2 of the present embodiment, the second wiring 25 in the electronic device 1 of the above embodiment is connected to the electrodes 34 provided to the first surface (upper surface) 32 of the IC chip 30 so as to cover them, and an insulating section described below is formed around the IC chip 30. Note that the whole surface of the electrodes 34 can preferably be coated with Ni or the like by plating for preventing oxidization of the electrodes 34. Further, it is also preferable to form protrusions (bumps) made of a metal material such as Al, Ni-Cr, Cu, Ni, Au, or Ag on the electrodes 34 to ensure electrical connections between the second wiring 25 and the electrodes 34. The plating and the protrusions described above are formed by an electroless plating process. The rest of the configuration of the electronic device 2 is the same as the configuration of the electronic device 1 of the first embodiment described above.
As shown in Fig. 4, the electronic device 2 is equipped with the substrate 5 and the pedestal 10 formed on the substrate 5. The pedestal 10 is arranged to be adhered onto the substrate 5 via the adhesive layer 12. Further, the first wiring 20 is formed on the substrate 5 by a plating process, a sputtering process, a sputtering mask process, a CVD process, or an inkjet process.

The end face of the pedestal 10 is provided with the incline 10a at an angle with the upper surface of the substrate 5. Note that the incline 10a preferably has an acute angle with the upper surface of the substrate 5. Further, the pedestal 10 is provided with the IC chip 30 mounted thereon. The IC chip 30 is arranged to be adhered onto the pedestal 10 via a adhesive layer 39. Further, in the side of the IC chip 30, there is provided an insulating section 40 so as to cover the side face of the IC chip 30. The insulating section 40 is provided with an incline 40a gradually sloping outside toward the surface of the pedestal. Therefore, the insulating section 40 is formed to have the incline so that the thickest portion thereof abuts on the IC chip 30 and the thinnest portion thereof is positioned furthest from the IC chip 30.

The insulating section 40 is formed of a material (e.g., resin) having an electrical insulation property. Note that the insulating section 40 can be formed of a different material from the adhesive layer 39 or can be formed of the same material as the adhesive layer 39. Further, the insulating section 40 can abut on the side face of the IC chip 30, as is the case with the present embodiment. In other words, it can be arranged that no gap is formed between the insulating section 40 and the IC chip 30. In an example shown in Fig. 4, the insulating section 40 is provided so as not to go beyond the height of the IC chip 30.
Therefore, the upper end of the insulating section 40 is arranged to be the same height as the upper surface (the surface of the passivation film 16) of the IC chip 30. In this case, by eliminating a step between the insulating section 40 and the IC chip 30, the second wiring 25 can smoothly abut on the insulating section 40 in the abutting section. The insulating section 40 can cover only a part of the side face of the IC chip 30 composed of a semiconductor or a conductive material. In this case, the upper end of the insulating section 40 is preferably the same height as the upper surface of the passivation film 16. Further, the insulating section 40 can be provided only to portions to which the second wiring 25 is provided. A part of the insulating section can be formed so as to run upon the passivation film 16.

In the electronic device 2, the second wiring 25 formed by a sputtering process and a photolithography process similarly to the case of the electronic device 1, as shown in Fig. 5, is connected to the first wiring 20 on the substrate 5, and is extended onto the upper surface of the pedestal 10 by laying down on the incline 10a shown in Fig. 4, and is further connected to the electrodes 34 formed on the upper surface (the first surface 32) of the IC chip 30 by laying down on the incline 40a of the insulating section 40.
Therefore, the connection section of the first wiring 20 with the second wiring 25 and the connection section of the electrodes 34 and the second wiring 25 are formed of their surfaces connected to each other.
The connection section between the first wiring 20 and the second wiring 25 is protected by covering the connection section and the IC chip 30 with the resin 35 to form a mold. By thus configured, since the wiring connection sections, the wiring sections, and the IC chip mounting sections are covered from the substrate with the resin, in particular the reliability in the moisture resistance property can be improved.

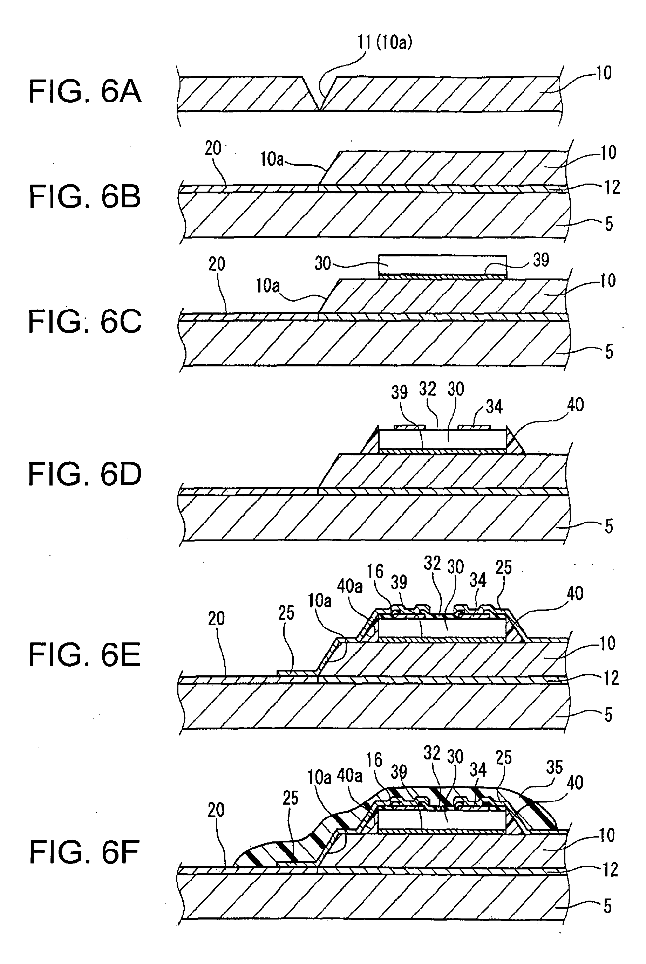

A method of manufacturing the electronic device 2 according to the present embodiment of the invention will now be described with reference to Figs 6A through 6F. Note that, in the present embodiment, a manufacturing process of the pedestal 10 shown in Fig. 6A and a bonding process of the pedestal 10 with the substrate 5 shown in Fig. 6B are the same, and the description therefor is omitted.

After bonding the pedestal 10 with the substrate 5, the IC chip 30 is then bonded on the pedestal 10 using the adhesive layer 39 as shown in Fig. 6C. Note that the IC chip 30 is schematically illustrated in Fig. 6C. Subsequently, as shown in Fig. 6G, the insulating section 40 is formed on the side face of the IC chip 30. In this case, the insulating section 40 is formed so as to have the incline 40a sloping toward the outside as coming closer to the bottom of the pedestal 10.
Further, the insulating section 40 can be made of resin such as polyimide resin, silicone modified polyimide resin, epoxy resin, silicone modified epoxy resin, benzocyclobutene (BCB), or polybenzooxazole (PBO). Still further, the insulating section 40 can be formed by dropping liquid resin or by fixing a dry film Note that the insulating section 40 can be formed of a different material from the adhesive for forming the adhesive layer 39, or made of the same material.
Further, the whole surfaces of the electrodes 34 of the IC chip 30 can preferably be covered with plating of Ni or the like. Thus, it can be prevented that an oxide film is formed on the electrodes 34. Further, it is also preferable to form protrusions (bumps) made of a metal material such as Al, Ni-Cr, Cu, Ni, Au, or Ag on the electrodes 34 to ensure electrical connections between the second wiring 25 and the electrodes 34.

Subsequently, as shown in Fig. 6E, the second wiring 25 that is connected to the first wiring and is also connected to the electrodes 34 provided on the upper side, namely the first side 32 of the IC chip30 is formed on the substrate 5.
As a method of forming the second wiring 25, similarly to the above embodiment, a metal film is coated so as to cover the first wiring 20 and the pedestal 10 by a sputtering process and a photolithography process. Various materials having superior conductivity can be adopted as a material of the metal film. Note that a plasma process can be executed prior to the sputtering process to enhance adhesiveness with the metal film. Note that the second wiring 25 can be formed by a plating process, a sputtering process, a sputtering mask process, a CVD process, or an inkjet process.
And then, the photoresist is coated on the whole surface of the metal film by a spray coating process, and then cured by a heat treatment process, thus the second wiring 25 with a desired pattern is formed by an exposure process and a development process.
In this case, as shown in Fig. 5, the second wiring 25 is connected to the first wiring 20 on the substrate 5, and the second wiring 25 and the first wiring 20 are arranged to be connected to each other with their surfaces. Further, the second wiring 25 is connected to the electrodes 34 of the IC chip 30 also with the surfaces thereof. Note that it is preferable to provide bumps or barrier metals in order for making it difficult to oxidize the surfaces of the electrodes 34 of the IC chip 30.
After then, as shown in Fig. 6F, the connection section between the first wiring 20 and the second wiring 25 and the IC chip 30 are covered with the resin 35 to form a mold.
The electronic device 2 according to the present embodiment of the invention is manufactured by the processes described above.

According to the electronic device 2 described above, similarly to the electronic device 1 in the previous embodiment, the second wiring 25 is formed so as to lap over the first wiring 20. Therefore, the first wiring 20 and the second wiring 25 can surely be connected electrically to each other, and the first wiring 20 and the second wiring 25 are connected to each other with their surfaces in the junction thereof on the substrate 5. Therefore, the strength of the junction between the first wiring 20 and the second wiring 25 can be increased to prevent breaking thereof, and the connection reliability in a reliability examination especially for the thermal cycle resistance, the bending resistance, or the dropping resistance can be enhanced.

Further, if at least a part of the end face of the pedestal 10 is formed as the incline 10a at an acute angle with the upper surface of the substrate 5, breaking caused by bending the second wiring 25 at a junction between the pedestal 10 and the substrate 5 can be prevented, thus enhancing the reliability of the electronic device 2. Further, if the IC chip 30 having an inclined surface is directly mounted on the substrate 5 without using the pedestal 10, breaking of the second substrate 25 can also be prevented similarly to the case with the pedestal 10, thus enhancing the reliability of the electronic device.

Further, since the IC chip 30 connected to the second wiring 25 is provided on the pedestal 10, the IC chip 30 provided on the pedestal 10 is connected to the second wiring 25, and is further electrically connected to the first wiring 20 provided on the substrate 5 via the second wiring 25.
Further, in order for connecting the second wiring 25 to the electrodes 34 formed on the upper surface of the IC chip 30, the second wiring 25 is formed after the IC chip 30 is provided on the pedestal 10. Therefore, the formation of the second wiring 25 and the connection of with the IC chip 30 can simultaneously be executed, thus the manufacturing process of the electronic device 2 can significantly be simplified. Further, since the photoresist can be patterned in accordance with the second wiring 25 by a photolithography process, the second wiring 25 can be formed in a fine pitch.

According to the method of manufacturing the electronic device 2 described above, the junction between the first wiring 20 and the second wiring 25 is connected to each other on the substrate 5 not with edges but with surfaces, the strength of the junction can be increased.
Therefore, the connection reliability can be enhanced by preventing breaking of the junction when external forces caused by, for example, bending or dropping are applied to the junction. Further, since the formation of the second wiring 25 and the connection with the first wiring 20 can be executed at the same time, the number of manufacturing steps can be reduced. This indicates that the more the number of connections requited for the structure is, the more advantages in reducing loads for processes can be obtained.
Further, breaking caused by bending the second wiring 25 at the junction between the pedestal 10 and the substrate 5 can be prevented by laying the second wiring 25 down on the incline 10a in the end face of the pedestal 10.

Further, since the second wiring 25 is formed so as to be connected to the electrodes 34 formed on the upper surface of the IC chip 30 after the IC chip 30 is provided on the pedestal 10, the formation of the second wiring 25 and the connection of the IC chip 30 with the second wiring 25 can be executed at the same time, thus the manufacturing method of the electronic device 2 can be simplified.

Further, since the insulating section 40 is provided on the side section of the IC chip 30, the second wiring 25 is insulated from the IC chip 30 in other portions than the electrodes 34 formed on the upper surface of the IC chip 30. Therefore, the short circuit between the second wiring 25 formed on the insulating section 40 and the side face of the IC chip 30 can be prevented. Further, since the surface of the IC chip 30 is covered with the passivation film 16, the short circuit between the IC chip 30 and the second wiring 25 can be prevented.
Further, since the insulating section 40 is provided with the incline 40a, breaking caused by acutely bending the second wiring 25 can be made difficult to occur by utilizing the incline 40a in laying down the second wiring on the side of the IC chip 30 provided with the electrodes 34. Further, since the incline 40a has an acute angle with the upper surface of the pedestal 10, the pitch of the second wiring 25 to the pedestal 10 becomes lower, thus preventing the second wiring 25 from breaking.
Further, similar to the incline 10a of the pedestal 10, when the second wiring 25 is formed on the incline 40a by a sputtering process, the incline 40a provided to the end face of the insulating section 40 faces the sputtering target to enhance the ability to cover an uneven surface, thus stabling the film thickness, and accordingly, the second wiring 25 can easily be formed. Therefore, the second wiring 25 surely connected thereto can be formed between the insulating section 40 and the pedestal 1 0. In the same way, if the second wiring 25 is formed by a sputtering process, a sputtering mask process, a CVD process, or an inkjet process, it can offer reliable connections between the insulation section 40 and the pedestal 10.

An electronic device according to a fourth embodiment of the invention is hereinafter described.

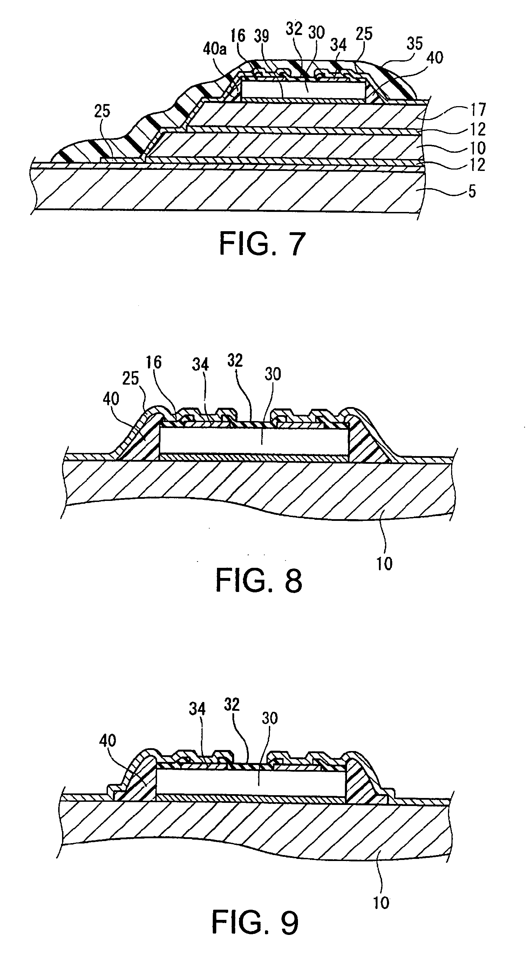

Fig. 7 is a side cross-sectional view for schematically showing the electrical device according to the fourth embodiment. Note that elements common to the first embodiment are denoted with the same reference numerals, and detailed descriptions therefor will be omitted.
As shown in Fig. 7, the pedestal 10 disposed on the substrate 5 is further provided with another pedestal 17 disposed thereon. In other wards, the pedestals 10, 17 are disposed on the substrate 5 in a two-tiered structure. Note that the structure of the pedestals is not limited to the two-tiered structure, but can be a multi-tiered structure.
Further, as a method of adhering the additional pedestal 17 to the pedestal 10, an adhering process using the adhesive layer 12 composed of an adhesive or the like or an adhering process without adhesives, such as room temperature bonding or interatomic bonding can be adopted. The end face of the pedestal 17 is provided with an incline at an acute angle with the substrate 5 similarly to the above embodiment.

The second wiring 25 is formed by a sputtering process and a photolithography process as explained in the first and the second embodiments described above. Further, as shown in Fig. 7, the second wiring 25 is laid down from the upper surface of the first wiring 20 to the upper surface (the first surface 32) of the IC chip 30 along the incline of the pedestal 10, the incline of the additional pedestal 17, and the incline 40a of the insulating section 40, and is connected to the electrodes 34 provided on the upper surface (the first surface 32) of the IC chip 30. Thus, the first wiring 20 and the electrodes 34 of the IC chip 30 are electrically connected to each other via the second wiring 25. Note that the second wiring 25 can be formed by a sputtering process, a sputtering mask process, a CVD process, or an inkjet process.

According to the electronic device of the present embodiment, the same effectiveness and advantages as those of the embodiments previously described can be obtained. Namely, in case the multi-tiered pedestals 10, 17 are stacked on the substrate 5, since the second wiring 25 is formed by a plating process or the like, the first wiring 20 and the second wiring 25 are surely bonded to each other with their surfaces, thus providing the electrical connection. Therefore, the electronic device having a multi-tiered structure can be provided.

Although, in the embodiments described above, the insulating section 40 is explained as formed around the IC chip 30 and provided with the incline 40a, the shape of the insulating section 40 can also be formed as below.
For example, as shown in Fig. 8, the insulating section 40 can be formed so that a part of the insulating section 40 runs on the first surface 32 (more precisely, the passivation film 16). The part of the insulating section 40 runs on a peripheral section of the IC chip 30 nearer to the edge thereof than the electrodes 34.
Further, in order for preventing the electrodes 34 from being covered with the insulating section 40, the part of the insulating section 40 can be stopped at a position apart from the electrodes 34 (and nearer to the periphery thereof than the electrodes). Alternatively, the insulating section 40 can be formed so as to adjoin a part of the electrodes 34 exposed from the passivation film 16. In this case, the second wiring 25 is assumed not to run on the passivation film 16 having low adhesiveness therewith. The insulating section 40 includes a protruding section higher than the first surface 32 adjacent to the IC chip 30. The configuration of other sections is corresponding to the same content of the IC chip 30 shown in Fig. 1.

Further, as shown in Fig. 9, the insulating section 40 can be formed so that a part of the insulating section 40 does not run on the first surface 32 of the IC chip 30. The insulating section 40 includes a protruding section higher than the first surface 32 adjacent to the IC chip 30. The insulating section 40 has a step-like section on the opposite side of the IC chip 30. The configuration of other sections is corresponding to the same content of the IC chip 30 shown in Fig. 1.

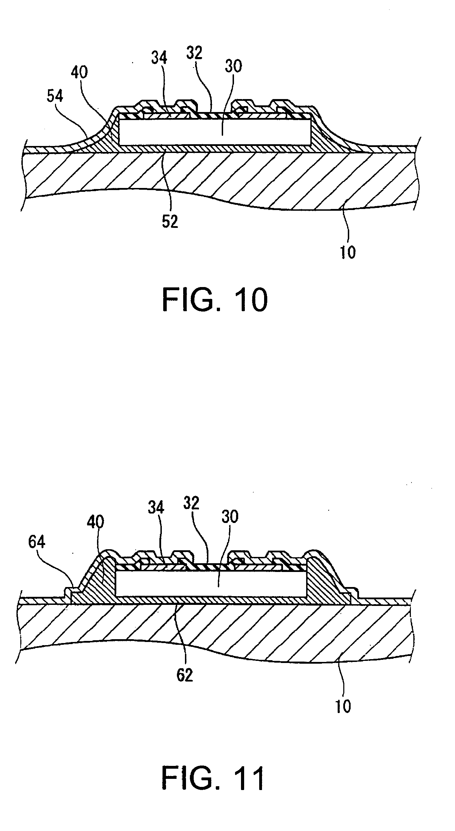

Further, as shown in Fig. 10, the insulating section 40 and the adhesive layer 52 can integrally be formed. The adhesive layer 52 is made of the same material as the insulating section 40. In this case, an insulating adhesive is provided between the pedestal 10 and the IC chip 30, and then a pressure is applied between the pedestal 10 and the IC chip 30 to push the adhesive to the adjacent area to the IC chip 30, and the insulating section 40 and the adhesive layer 52 can finally be formed from the adhesive.
The incline 54 of the insulating section 40 is a concave (e.g., a concave defined by writing a curve in a cross-section perpendicular to the first surface 32). The configuration of other sections is corresponding to the same content of the IC chip 30 shown in Fig. 1.

Further, as shown in Fig. 11, the insulating section 40 and the adhesive layer 62 can integrally be formed. The adhesive layer 62 is made of the same material as the insulating section 40. An insulating adhesive is provided between the pedestal 10 and the IC chip 30, and then a pressure is applied between the pedestal 10 and the IC chip 30 to push the adhesive to the adjacent area to the IC chip 30, and the insulating section 40 and the adhesive layer 62 can finally be formed from the adhesive. The incline 64 of the insulating section 40 is a convex (e.g., a convex defined by writing a curve in a cross-section perpendicular to the first surface 32). The configuration of other sections is corresponding to the same content of the IC chip 30 shown in Fig. 1.

The invention is not limited to the embodiments described above, but various modifications are possible. For example, the second wiring 25 is formed on the outer end surface of the pedestal 10. However, if an opening is provided to the pedestal 10, the wiring can be laid down on the inner side surface (the end surface) of the opening to provide the electrical connection by connecting it to the wiring formed in the opening. Further, the additional component formed on the pedestal 10 is explained as the IC chip 30 in the present embodiments, it can be a passive component (e.g., a resistor, a capacitor, an inductor, and so on) instead of the IC chip 30. A number of various kinds of such passive components can also be mounted.

## Claims

1. An electronic device comprising:
a substrate provided with a first wiring formed thereon; and
a pedestal provided above the substrate and provided with a second wiring formed thereon,
wherein the second wiring is connected to the first wiring on the substrate.

2. The electronic device according to Claim 1, wherein at least a part of an end face of the pedestal forms an incline at an angle with an upper surface of the substrate.

3. The electronic device according to Claim 2, wherein the angle formed by the incline with the upper surface of the substrate is an acute angle.

4. The electronic device according to Claim 1, wherein an additional component connected to the second wiring is mounted on the pedestal.

5. The electronic device according to Claim 4, wherein the second wiring is connected to an upper surface of the additional component.

6. The electronic device according to Claim 4, wherein the additional component is an IC chip.

7. The electronic device according to Claim 1, wherein the pedestal includes a plurality of sub-pedestals stacked one another.

8. An electronic device comprising:
a substrate provided with a first wiring formed thereon; and
an additional component provided above the substrate and provided with a second wiring formed on an upper surface thereof,
wherein the second wiring is connected to the first wiring on the substrate.

9. The electronic device according to Claim 8, wherein the additional component is an IC chip.

10. A method of manufacturing an electronic device, comprising:
forming a first wiring and a pedestal on a substrate; and
forming a second wiring above the substrate so as to be connected to the first wiring on the substrate and is laid down onto the pedestal.

11. The method of manufacturing an electronic device according to Claim 10, wherein at least a part of an end face of the pedestal forms an incline at an angle with an upper surface of the substrate.

12. The method of manufacturing an electronic device according to Claim 11, wherein the angle formed by the incline with the upper surface of the substrate is an acute angle.

13. The method of manufacturing an electronic device according to Claim 10, wherein an additional component connected to the second wiring is mounted on the pedestal.

14. The method of manufacturing an electronic device according to Claim 13, further comprising:
mounting the additional component on the pedestal,
wherein, in the step of forming the second wiring, the second wiring is connected to an upper surface of the additional component.

15. The method of manufacturing an electronic device according to Claim 13, wherein the additional component is an IC chip.

16. The method of manufacturing an electronic device according to Claim 15, further comprising:
providing an insulating section to at least a part of a side of the IC chip, an end face of the insulating section forming an incline at an angle with an upper surface of the pedestal.

17. The method of manufacturing an electronic device according to Claim 16, wherein the angle formed by the incline with the upper surface of the pedestal is an acute angle.
